# EUROPÄISCHE PATENTSCHRIFT

(11) **EP 2 279 533 B1**
(45) Veröffentlichungstag und Bekanntmachung des Hinweises auf die Patenterteilung: **09.01.2019**
(21) Anmeldenummer: 09753513.2
(22) Anmeldetag: 17.04.2009
(51) Int. Cl.: H01L 31/167, H01L 33/00, G01V 8/12, H01L 25/16, H01L 31/0203

(54) **HALBLEITERBAUELEMENT, REFLEXLICHTSCHRANKE UND VERFAHREN ZUR HERSTELLUNG EINES GEHÄUSES DAFÜR**
SEMICONDUCTOR COMPONENT, REFLECTED-LIGHT BARRIER AND METHOD FOR PRODUCING A HOUSING THEREFOR
COMPOSANT SEMICONDUCTEUR, BARRIÈRE PHOTOÉLECTRIQUE À RÉFLEXION ET PROCÉDÉ DE FABRICATION D UN BOÎTIER À CET EFFET

(30) Priorität: 26.05.2008 DE 102008025159
(43) Veröffentlichungstag der Anmeldung: 02.02.2011
(73) Patentinhaber: OSRAM Opto Semiconductors GmbH, 93055 Regensburg (DE)
(72) Erfinder: ZITZLSPERGER, Michael, 93047 Regensburg (DE); ZEILER, Thomas, 93152 Nittendorf (DE)
(74) Vertreter: Zacco Patent- & Rechtsanwälte
(86) Internationale Anmeldenummer: PCT/DE2009/000545
(87) Internationale Veröffentlichungsnummer: WO 2009/143797

(56) Entgegenhaltungen:
- EP-A- 0 493 051
- EP-A- 1 079 443
- DE-A1- 2 656 185
- JP-A- 8 130 325
- JP-A- 58 093 388
- US-A- 4 309 605
- US-A- 5 340 993
- US-A1- 2006 016 970
- US-A1- 2008 012 125

## Beschreibung

Die Anmeldung betrifft ein Halbleiterbauelement gemäß Anspruch 1, eine Reflexlichtschranke gemäß Anspruch 6 sowie ein Verfahren zur Herstellung eines Gehäuses für eine Reflexlichtschranke gemäß Anspruch 7. Bauelemente mit einem strahlungsundurchlässigen Gehäuse und darin angeordneten Halbleiterchips sind beispielsweise in den Druckschriften US 2006/0016970 und JP 08-130 325 beschrieben. Zum Detektieren von Objekten innerhalb eines bestimmten Gebietes werden Lichtschranken verwendet. Eine Lichtschranke ist ein elektronisch-optisches System mit einem Emitter und einem Detektor. Als Emitter wird im Folgenden ein eine elektromagnetische Strahlung aussendender Halbleiterchip angesehen. Der Emitter wird auch als Sender oder Strahlungsquelle bezeichnet. Der aussendende Halbleiterchip kann beispielsweise eine Infrarotstrahlung oder sichtbares Licht aussenden und ist bevorzugt eine Leuchtdiode oder eine Laserdiode. Der Detektor hingegen ist ein eine elektromagnetische Strahlung detektierender Halbleiterchip, welcher auch als Sensor oder Empfänger bezeichnet wird. Der Detektor ist sensitiv für die ausgesendete Strahlung des Emitters. Der detektierende Halbleiterchip ist bevorzugt ein Fototransistor, ein Fotowiderstand oder eine Fotodiode.

Das Funktionsprinzip einer Lichtschranke wird im folgenden kurz erläutert. Der Emitter sendet eine elektromagnetische Strahlung eines bestimmten Wellenlängenbereich mit einer entsprechenden Lichtstärke I aus. Der Detektor ist zumindest für diesen bestimmten Wellenlängenbereich der Strahlung sensitiv. Durch ein zu detektierendes Objekt in der Lichtschranke wird der Strahlengang zwischen Emitter und Detektor verändert. Im Detektor wird die resultierende Veränderung der auftreffenden Leuchtdichte der Strahlung registriert. Diese Registrierung wird in einem Folgeschritt in ein elektrisches Schaltsignal umgesetzt, welches anschließend weiter verarbeitet wird.

Als Leuchtdichte L ist das Verhältnis der ausgestrahlten Lichtstärke I zur Größe A ihrer scheinbaren leuchtenden Fläche definiert. Die Leuchtdichte hat die SI-Einheit Candela cd pro Quadratmeter m². Die Leuchtdichte ist die fotometrische Entsprechung zur Strahlungsdichte *L*(λ) mit der Einheit Watt*Meter⁻²*Steradiant⁻¹ bzw. W·m⁻²·sr⁻¹ der Radiometrie.

Man unterscheidet Lichtschranken prinzipiell zwischen Einweglichtschranken und Reflexlichtschranken. Bei Einweglichtschranken stehen sich Emitter und Detektor gegenüber, wobei die Hauptabstrahlrichtung des Emitters direkt in Richtung Detektor liegt. Der Detektor detektiert demnach ständig die Leuchtdichte, die vom Emitter verursacht wird. Sobald ein Objekt in den Strahlengang zwischen Emitter und Detektor tritt, wird der Strahlengang unterbrochen. Das daraus folgende Nichtdetektieren der ausgesendeten Strahlung des Emitters wird in einer weiter verarbeitenden Einheit ausgewertet.

Bei Reflexlichtschranken stehen sich im Unterschied zur Einweglichtschranke Emitter und Detektor nicht gegenüber und befinden sich darüber hinaus bevorzugt in einem gemeinsamen Gehäuse. Dadurch ist der Aufbau weniger aufwendig. Prinzipiell werden bei Reflexlichtschranken zwei Methoden zum Detektieren von Objekten unterschieden.

Bei der ersten Methode ist ein reflektierendes Element auf einer ersten Seite, das Gehäuse mit Emitter und Detektor auf einer gegenüberliegenden Seite angeordnet. Das Element und das Gehäuse sind derart ausgerichtet, dass eine Unterbrechung des Strahlengangs durch ein Objekt, eine Leuchtdichteänderung im Detektor hervorruft.

Alternativ wird kein Reflektor verwendet. Ist ein Objekt im Strahlengang des Emitters, so trifft die Strahlung des Emitters auf das Objekt und wird an der Objektoberfläche aufgrund der Oberflächengestaltung des Objektes gestreut. Durch die Streuung wird ein Teil der ausgesendeten Strahlung auf den Detektor treffen. Die Änderung der Leuchtdichte im Detektor wird registriert.

Zunehmend werden Detektor und Emitter auf einem Träger innerhalb eines Gehäuses untergebracht. Werden Detektor und Emitter in einem Gehäuse untergebracht, ist ein Kurzschließen des optischen Signalpfades zu verhindern. Ein direkter Strahlengang von Emitter zu Detektor ist also zu unterbinden. Hierzu werden bislang optische Barrieren in das Gehäuse eingebracht, die zwischen Emitter und Detektor platziert sind. Diese Barrieren werden nachträglich mittels Klebemittel in das Gehäuse eingebracht. Die verwendeten Klebemittel sind jedoch transparent für die aussendende elektromagnetische Strahlung. Durch diese Barrieren ist ein Kurzschließen des optischen Signalpfades somit nicht auszuschließen.

Es ist daher Aufgabe der Erfindung, ein Halbleiterbauelement, eine Reflexlichtschranke sowie ein Verfahren zu der Herstellung eines Gehäuses für eine Reflexlichtschranke anzugeben, welche sehr einfach realisiert werden und ein direktes Kurzschließen des optischen Signalpfades zwischen verhindern.
Die Aufgabe wird mit den in den nebengeordneten Patentansprüchen angegebenen Maßnahmen gelöst.

Es ist dazu ein Halbleiterbauelement gemäß Anspruch 1 mit einem monolithischen Gehäuseunterteil vorgesehen. Das Gehäuseunterteil weist eine Oberseite und zumindest eine erste und eine zweite Kavität auf, wobei die Kavitäten zu der Oberseite des Gehäuseunterteils offen sind. In die erste Kavität ist zumindest ein eine elektromagnetische Strahlung aussendender Halbleiterchip angeordnet. In der zweiten Kavität ist zumindest ein eine elektromagnetische Strahlung detektierender Halbleiterchip, angeordnet. Das Gehäuseunterteil ist aus einem Material, welches die ausgesendete elektromagnetische Strahlung absorbiert oder reflektiert.
Durch die monolithische, in anderen Worten einstückige Ausgestaltung des Gehäuseunterteils, ist eine gute optische Trennung zwischen aussendendem und detektierendem Halbleiterchip gegeben. Ein Kurzschließen des optischen Signalpfades ist nun nicht mehr möglich. Dadurch, dass das Gehäuseunterteil monolithisch ausgestaltet ist, sind keine zusätzlichen Barrieren mit einem Klebemittel in die Gehäuseanordnung einzubringen. Der Aufbau ist somit einfach und kostengünstig realisiert.

Das Halbleiterbauelement weist einen Leiterbahnrahmen auf, auf dem die Halbleiterchips angeordnet sind. Der Leiterbahnrahmen ist undurchlässig für die aussendende oder zu detektierende Strahlung. Zusätzlich ist der Leiterbahnrahmen durch die Unterseite des Halbleiterbauelements direkt elektrisch leitend kontaktierbar.
Da die aussendenden und die detektierenden Halbleiterchips auch auf der Rückseite des Chips aktiv sind deshalb auch auf der Rückseite der Chips Strahlung ausgesendet bzw. detektiert werden kann, ist durch einen derart geformten Leiterbahnrahmen eine Einkopplung von aussendender Strahlung in das detektierende Element auf der Rückseite verhindert. Ist der Leiterbahnrahmen Bestandteil einer Leiterplatte so ist dessen Material ebenfalls absorbierend oder reflektierend für die auszusendende und detektierende Strahlung. Zusätzlich ist durch den Leiterbahnrahmen eine elektrische Kontaktierung der Halbleiterchips erreicht.

In einer weiteren Ausgestaltung gemäß Anspruch 7 ist das Gehäuseunterteil mittels Spritzguss- beziehungsweise Spritzpress-Verfahren hergestellt. Mittels dieser Verfahren ist es sehr einfach möglich das Gehäuseunterteil mit den Kavitäten auszugestalten ohne zusätzliche Barrieren in das Gehäuseunterteil aufbringen zu müssen.
In einer weiteren Ausgestaltung ist zusätzlich ein Gehäuseoberteil vorgesehen, welches zumindest teilweise transparent für die aussendende und die zu detektierende Strahlung ist. Durch dieses Gehäuseoberteil ist zunächst ein Schutz der Halbleiterchips gegeben. Um zu vermeiden, dass die ausgesendete und die detektierte elektromagnetische Strahlung blockiert werden, ist das Gehäuseoberteil zumindest teilweise transparent. Zusätzlich ist durch das Gehäuseoberteil eine verbesserte optische Ankopplung an das Übertragungsmedium Luft erzielt. Da das Gehäuseoberteil direkt in die Kavitäten eingebracht ist und durch das Einbringen eine ausreichende Haltekraft zwischen Gehäuseoberteil und Gehäuseunterteil erzielt ist, ist die Verwendung bzw. das Einbringen zusätzlicher Klebemittel nicht nötig. Schlussfolgernd ist eine kostengünstigere Herstellung dieses Halbleiterbauelements erzielt.
In einer weiteren Ausgestaltung ist das Gehäuseoberteil zusätzlich mit einem optischen Element versehen. Als optisches Element ist beispielsweise eine Linse oder auch ein Linsenarray vorzusehen. Durch das optische Element werden die aussendende und auch die zu detektierende Strahlung gebündelt und/ oder umgelenkt. Dies führt emitterseitig zu einer konzentrierten Aussendung der Strahlung, wodurch das Halbleiterbauelement eine höhere Reichweite erzielt. Detektorseitig ist durch das optische Element ein verbessertes Detektieren der elektromagnetischen Strahlung erreicht.

Das Halbleiterbauelement weist zusätzlich einen dritten Halbleiterchip in einer dritten Kavität des Gehäuseunterteils auf. Dieser dritte Halbleiterchip ist entweder eine anwendungsspezifische Schaltungsanordnung, englisch Application specific integrated Circuit (ASIC) oder eine Schaltungsanordnung gegen elektrostatische Entladung, englisch Electrostatic Discharge (ESD) Chip. Dieser dritte Halbleiterchip steuert zum einen das Aussenden der elektromagnetischen Strahlung, beispielsweise mittels Intensitätssteuerung oder Modulation und zum anderen die Auswertung der detektierten Strahlung. Der dritte Halbleiterchip kann mittels Abdeckmasse, auch als Globetop bezeichnet, vergossen sein.

Der dritte Halbleiterchip wird bereits vor dem Herstellen des Gehäuseunterteils auf dem Leiterbahnrahmen platziert und beispielsweise im Spritzguss- und Spritzpress-Verfahren komplett mit dem Material des Gehäuseunterteils umgossen. Der dritte Halbleiterchip, der möglicherweise durch die Strahlung manipuliert wird, zerstört oder falsch funktioniert, ist somit speziell vor der Strahlung geschützt.
Es ist weiter vorgesehen eine Reflexlichtschranke mit einem der bereits genannten Halbleiterbauelemente auszugestalten. Weiterhin ist ein Verfahren zur Herstellung eines Gehäuses für eine Reflexlichtschranke gemäß Anspruch 7 vorgesehen.

Dieses Verfahren ist kosteneffizienter realisierbar. Es ist weder das Einbringen von Barrieren noch ein zusätzliches Klebemittel nötig, um Emitter und Detektor optisch voneinander zu trennen bzw. zu isolieren. Zusätzlich weisen mit diesem Verfahren hergestellte Halbleiterbauelemente gute Leistungsmerkmale auf.
Der Leiterbahnrahmen ist beispielsweise geätzt, gestanzt oder mittels Laserverfahrens hergestellt. Durch diese Form der Herstellung ist der Leiterbahnrahmen in weiten Grenzen frei gestaltbar, insbesondere die Zahl der Kavitäten ist nicht begrenzt.

Ein dritter Halbleiterchip wird zunächst auf dem Leiterbahnrahmen platziert und erst im Folgeschritt das Gehäuseunterteil hergestellt. Hierdurch ist ein Umspritzen des dritten Halbleiterchips ohne zusätzliche weitere Vergussmasse möglich. Durch den Einsatz von die aussendende und/oder detektierende Strahlung absorbierenden oder reflektierenden Materialien, ist der dritte Halbleiterchip von der elektromagnetischen Strahlung entkoppelt.
Zusätzlich ist eine zweite Vergussmasse vorgesehen, die in die Kavitäten eingefüllt werden kann und zumindest teilweise transparent für die auszusendende oder zu detektierende Strahlung ist. Mittels eines Compression mold- Verfahren ist in einer weiteren Ausgestaltung die Formung eines optischen Elements möglich.
Nachfolgend werden Ausführungsbeispiele der Erfindung anhand von Figuren beschrieben. Die Figuren weisen hierbei gleich oder gleich wirkende Bestandteile mit den gleichen Bezugszeichen auf. Die dargestellten Elemente sind nicht als maßstabsgerecht anzusehen, vielmehr können einzelne Elemente zum besseren Verständnis übertrieben groß beziehungsweise übertrieben vereinfacht dargestellt sein.

Es zeigen:
Figur 1a und 1b Funktionsprinzip einer Reflexlichtschranke,
Figur 2 ein Beispiel, das nicht Teil der beanspruchten Erfindung bildet, eines Halbleiterbauelements mit einem monolithischen Gehäuseunterteil ,
Figur 3 eine Weiterbildung des in Figur 2 dargestellten Beispiels,
Figur 4 eine Weiterbildung des in Figur 3 dargestellten Beispiels,
Figur 5 eine Draufsicht des in Figur 2 dargestellte Beispiels,
Figur 6 eine Draufsicht eines zur Figur 2 alternativen Beispiels,
Figur 7 ein Ausführungsbeispiel und eine Weiterbildung des in Figur 6 dargestellten Beispiels,
Figur 8 ein Beispiel, das nicht Teil der beanspruchten Erfindung bildet, und eine Alternative zum in Figur 7 dargestellten Ausführungsbeispiels,
Figur 9 eine dreidimensionale Darstellung des in Figur 2 dargestellten Beispiels,
Figur 10 eine Rückansicht des in Figur 9 dargestellten Beispiels,
Figur 11 eine dreidimensionale Darstellung des in Figur 7 dargestellten Ausführungsbeispiels,
Figur 12 eine dreidimensionale Darstellung des in Figur 4 dargestellten Beispiels.

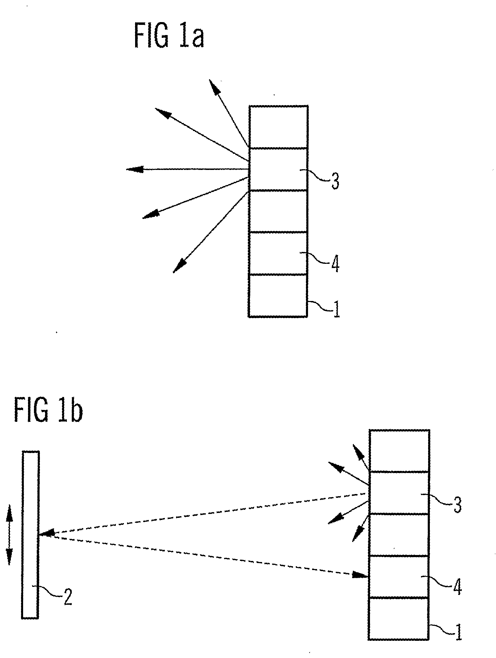

In Figur 1a und 1b ist das Funktionsprinzip einer Reflexlichtschranke vorgesehen. In Figur 1a ist Halbleiterbauelement 1 mit einem eine elektromagnetische Strahlung aussendenden Halbleiterchip 3, im Folgenden als Emitter bezeichnet, und einem eine elektromagnetische Strahlung detektierenden Halbleiterchip 4, im Folgenden als Detektor bezeichnet, dargestellt. Als Emitter ist bevorzugt eine Laserdiode oder eine Leuchtdiode verwendet. Die Wellenlänge der ausgesendeten Strahlung ist grundsätzlich flexibel. Im Idealfall detektiert der Detektor Strahlung, die vom Emitter ausgesendet wird. Dadurch weisen die ausgesendete und die reflektiere Strahlung zumindest teilweise den gleichen Spektralbereich auf. Als Detektorhalbleiterchip 4 ist bevorzugt ein Fototransistor eine Fotodiode oder ein Fotowiderstand einzusetzen. Auf eine detaillierte Beschreibung von Detektor und Emitter wird an dieser Stelle verzichtet.
Befindet sich kein Objekt in der Reichweite der Lichtschranke wird die ausgesendete elektromagnetische Strahlung nicht reflektiert oder gestreut, wodurch der Detektorhalbleiterchip 4 keine Strahlung detektiert. In Figur 1b befindet sich nun ein Objekt 2 im Strahlengang des Halbleiterbauelements 1. Am Objekt 2 wird die auftreffende Strahlung gestreut und zumindest teilweise auf den Detektorhalbleiterchip 4 zurückstrahlen.
Grundsätzlich ist auch eine zweite Methode zur Realisierung einer Lichtschranke möglich, in dem ein Reflektor anstelle des Objektes vorhanden ist, wodurch zunächst stets eine Strahlung im Halbleiterchip 4 detektiert wird. Wenn nun ein Objekt zwischen Reflektor und Halbleiterbauelement 1 auftritt, wird der Strahlengang zumindest teilweise unterbrochen wodurch die Strahlintensität geändert ist. Diese Änderung wird im Detektor erfasst.

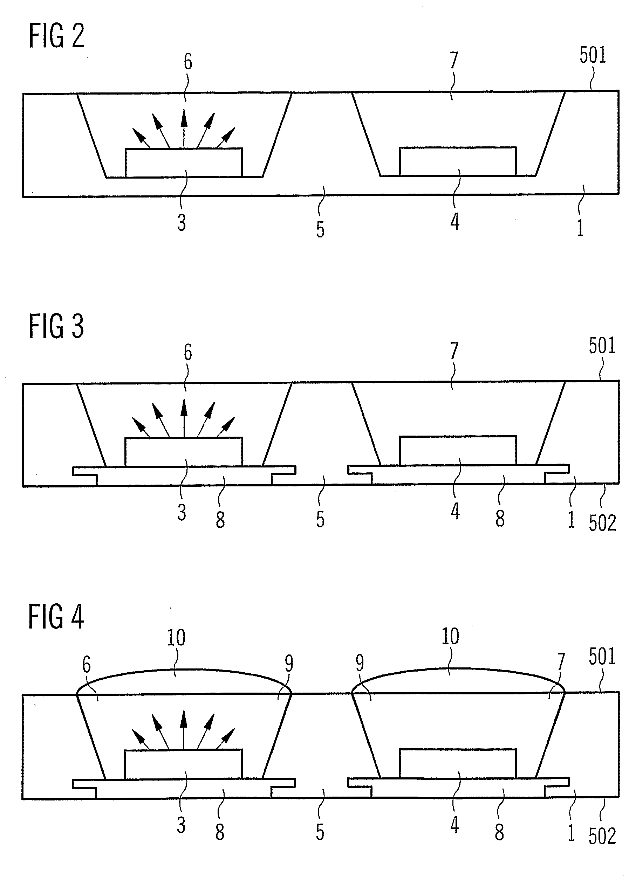

In Figur 2 ist ein Querschnitt eines in Figur 1 dargestellten Halbleiterbauelements 1 dargestellt. Hierzu weist das Halbleiterbauelement ein Gehäuseunterteil 5 auf. Dieses Gehäuseunterteil ist monolithisch, also einstückig aufgebaut. Es weist eine erste Kavität 6 und eine zweite Kavität 7 auf. In der ersten Kavität 6 ist der Emitter 3 angeordnet. In der zweiten Kavität 7 ist der Detektor 4 angeordnet. Die Kavitäten 6 und 7 sind zu einer Oberseite 501 des Gehäuseunterteils 5 geöffnet.

Das Material des Gehäuseunterteils 5 ist für die auszusendende elektromagnetische Strahlung absorbierend oder reflektierend. Das bedeutet, dass die ausgesendete elektromagnetische Strahlung nicht durch das Gehäuseunterteil 5 hindurch dringen kann.

Das Material des Gehäuses ist bevorzugt ein Epoxydharz oder eine Hybridmasse bestehend aus Silikon und Epoxyd. Alternativ ist das Gehäusematerial eine reine Silikonpressmasse. Diese Silikonpressmasse enthält Füllstoffe, um die mechanischen und optischen Eigenschaften des Gehäuseunterteils 5 an die anzupassen oder zu verbessern. Grundsätzlich dienen diese Pressmassen als Umhüllung für ein Leadframe und bilden das Gehäuseunterteil eines Halbleiterbauelements, einer Reflexlichtschranke oder ähnlichen.

Durch das monolithische Ausformen des Gehäuseunterteils ist ein Kurzschließen des optischen Signalpfades zwischen Emitter 3 und Detektor 4 nicht möglich. Da die Emitter und Detektor in alle Richtungen Strahlung aussenden können ist bei diesem Ausführungsbeispiel auch ein Unterwandern des Gehäuseunterteils 5 ausgeschlossen.
Durch die monolithische Ausformung ist weiterhin ein festeres und stabileres Gehäuseunterteil als beim herkömmlichen Aufkleben einer Barriere zwischen die Halbleiterchips 3 und 4 erzeugt. Das Gehäuse ist in weiten Grenzen frei gestaltbar insbesondere die Anzahl der Kavitäten und deren Formgebung ist nicht begrenzt.
In Figur 3 ist eine Weiterbildung des in Figur 2 dargestellten Beispiels dargestellt. Im Folgenden wird nur auf die Unterschiede zwischen der Figur 2 und Figur 3 eingegangen. Zusätzlich weist Figur 3 einen Leiterbahnrahmen 8, auch als Leadframe bezeichnet, auf, auf dem der Emitter 3 und der Detektor 4 angeordnet sind. Der Leiterbahnrahmen 8 ist durch eine der Oberseite 501 gegenüberliegenden Unterseite 502 elektrisch leitend kontaktiert. Alternativ ist eine Kontaktierung des Leiterbahnrahmens 8 ebenfalls über andere Seiten des Gehäuseunterteils 5 möglich. Alternativ kann für den Leiterbahnrahmen auch eine Leiterplatte, oft auch als Printed Circuit Board (PCB) bezeichnet, verwendet werden. Der Leiterbahnrahmen 8 und das PCB sind insbesondere lichtundurchlässig für die auszusendende oder zu detektierende Strahlung. Dadurch ist ein Unterwandern über die Gehäuseunterseite 802 ebenfalls ausgeschlossen.

Der Leiterbahnrahmen 8 ist in einem alternativen Beispiel flexibel und ermöglicht mit einem Minimum an Bondverbindungen mehrere Chips in einem Halbleiterbauelement 3 zu kombinieren.

Zur Herstellung eines Beispiels nach Figur 3 wird zunächst der Leiterbahnrahmen 8 gestanzt, geätzt oder mittels Laser ausgeschnitten. Im Folgeschritt wird mittels Spritzguss- oder Spritzpressverfahren eine erste Vergussmasse, beispielsweise ein Epoxydharz, ein Hybridmaterial oder eine Silikonpressmasse um den Leiterbahnrahmen 8 zumindest teilweise umspritzt. Dabei werden Kavitäten 6 und 7 vorgesehen, die zu einer Oberseite 501 offen sind. Im Folgeschritt werden der Emitter 3 und der Detektor 4 elektrisch leitend mit dem Leiterbahnrahmen 8 verbunden.
In Figur 4 ist eine Weiterbildung des in Figur 3 dargestellten Beispiels dargestellt. Auch hier wird nur auf die Unterschiede zwischen Figur 3 und Figur 4 eingegangen, um Wiederholungen zu vermeiden. Zusätzlich zur Figur 3 ist in Figur 4 ein Gehäuseoberteil 9 in die erste und zweite Kavität 6 und 7 eingebracht. Dieses Gehäuseoberteil ist in diesem Ausführungsbeispiel als optisches Element 10 ausgeformt. Dieses Gehäuseoberteil 9 ist bevorzugt zumindest teilweise transparent für die auszusendende und zu detektierende elektromagnetische Strahlung. Mittels Compression Molding- Verfahren ist dieser Verguss in die Kavitäten 6 und 7 eingebracht, sodass das optische Element 10 entsteht. Dadurch ist das zusätzliche Aufbringen von Linsen als optisches Element als zusätzlicher Herstellungsschritt gespart. Mittels dieser Anordnung ist eine sehr präzise Ausrichtung von Chips und Optik erreicht.

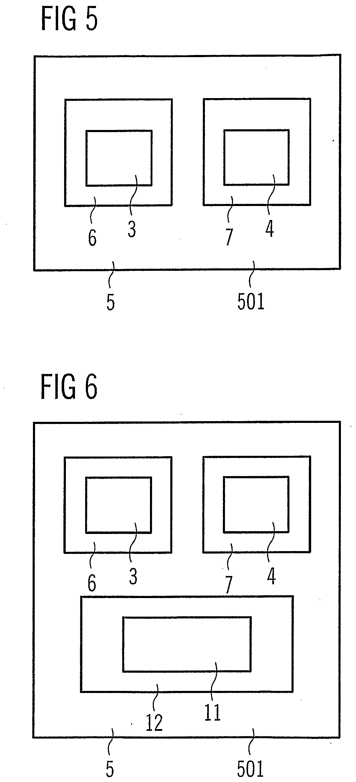

In Figur 5 ist eine Draufsicht des in Figur 2 dargestellten Beispiels dargestellt. Die Oberseite von Figur 1 ist hierbei dem Betrachter zugewandt.
In Figur 6 ist eine Weiterbildung des in Figur 5 dargestellten Beispiels dargestellt. In einer dritten Kavität 12 des Gehäuseoberteils 5 ist ein dritter Halbleiterchip 11 eingebracht. Dieser dritte Halbleiterchip 11 ist ein ASIC oder ein ESD-Chip. In dem dritten Halbleiterchip 11 sind die Auswerteschaltungen des Detektors 4 beziehungsweise auch die Ansteuerschaltungen für den Emitter 3 integriert. Durch die in Figur 6 dargestellte Ausführungsform ist eine vollständige Reflexlichtschranke mit sehr einfachen Mitteln kostengünstig herstellbar.

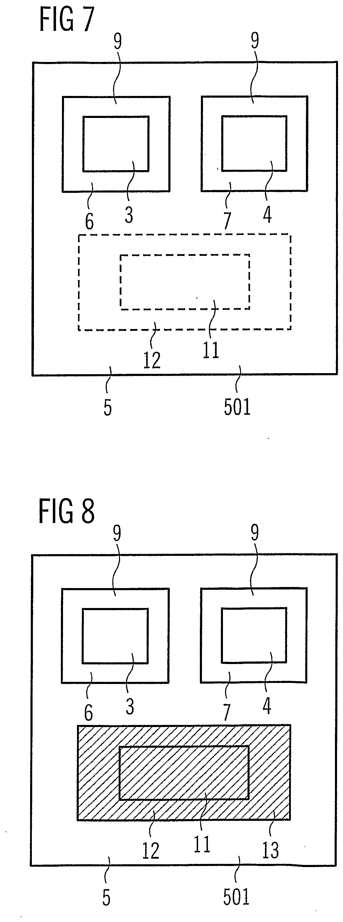

In Figur 7 ist ein Ausführungsbeispiel und eine Weiterbildung des in Figur 6 dargestellten Beispiels dargestellt. Die Kavität 12 und der dritte Halbleiterchip 11 sind hierbei gestrichelt dargestellt, da die dritte Kavität 12 und der darin befindliche dritte Halbleiterchip 11 bereits mittels des Gehäuseunterteils 5 umgossen, beziehungsweise umspritzt sind. Dieses Umspritzen geschieht bevorzugt nach der Platzierung des dritten Halbleiterchips 11 auf dem Leiterbahnrahmen 8 und vor der Herstellung des Gehäuseoberteils 5. Dadurch ist der dritte Halbleiterchip 11 vor der ausgesendeten Strahlung geschützt. Dieser Schutz ist mitunter nötig, um die hochenergetische Strahlung nicht auf den dritten Halbleiterchip 11 treffen zu lassen. Durch diese Bestrahlung könnte der Halbleiterchip manipuliert oder zerstört werden. Ein zusätzlicher Globetop ist in dieser Ausführungsform nicht nötig, wodurch wiederum ein Verfahrensschritt gespart ist. Nachträgliche Maßnahmen zum Schutz vor der Strahlung können so entfallen.

Durch alle dargestellten Varianten ist eine sehr effektive optische Trennung von Sender und Detektor erreicht und zusätzlich ein geringer Platzverbrauch dargestellt. Die mechanische Festigkeit ist erhöht. Zusätzlich ist in Figur 7 das Gehäuseoberteil 9 in die Kavitäten 1 und 2 eingebracht.

In Figur 8 ist ein zur Figur 7 alternatives Beispiel dargestellt. Anstelle der Ummantelung mittels des Gehäuseunterteils 5 ist in die Kavität 12 ein Globetop eingebracht um den Halbleiterchip 11 vor der ausgesendeten Strahlung zu schützen.

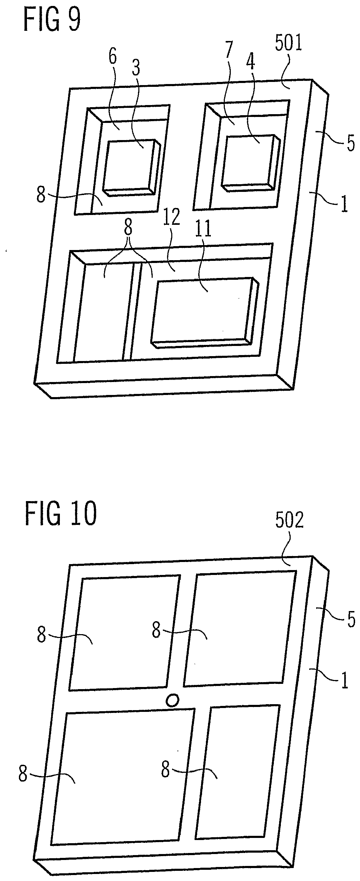

In Figur 9 ist eine dreidimensionale Darstellung des in Figur 6 dargestellten Beispiels dargestellt.
In Figur 10 ist eine Rückansicht des in Figur 9 dargestellten Beispiels dargestellt. Es ist zu sehen, dass der Leiterbahnrahmen 8 große Flächen aufweist, um zum einen eine gute elektrische Kontaktierung zu ermöglichen, und zum anderen um ein Rückkoppeln der ausgesendeten elektromagnetischen Strahlung in den Detektor 4 und somit ein Kurzschließen des optischen Signalpfades zu verhindern.

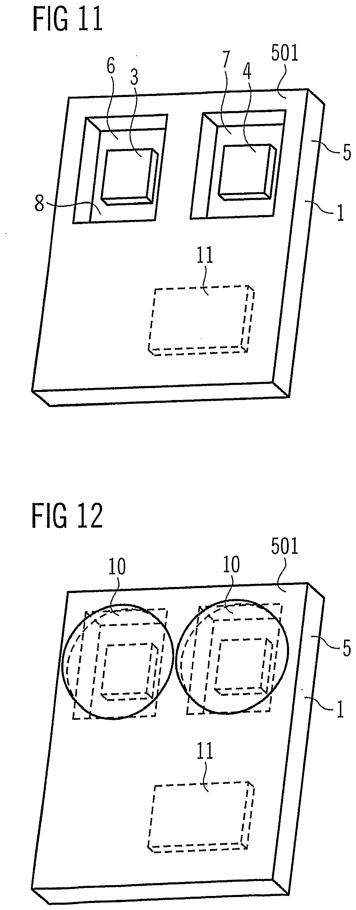

In Figur 11 ist das in Figur 7 dargestellte Ausführungsbeispiel dreidimensional dargestellt. In Figur 12 ist ein dreidimensionales Abbild des in Figur 4 dargestellten Beispiels dargestellt. Die optischen Elemente 10 dienen hierbei der verbesserten und angepassten Strahllenkung und können die elektromagnetische Strahlung bündeln, streuen und weiterleiten.
Es ist mitunter möglich mehrere Emitter 3 sowie mehrere Detektoren 4 in einem Halbleiterbauelement 1 unterzubringen.

Als emittierenden und detektierenden Halbleiterchip 3 beziehungsweise 4 ist bevorzugt ein Lambert-Strahler verwendet.

## Patentansprüche

1. Halbleiterbauelement (1) mit:
- einem monolithischen Gehäuseunterteil (5), wobei das Gehäuseunterteil (5) eine Oberseite (501) aufweist und zumindest eine erste und eine zweite Kavität (6, 7) aufweist, wobei die Kavitäten (6,7) zu der Oberseite (501) des Gehäuseunterteils (5) offen sind,
- zumindest einem eine elektromagnetische Strahlung aussendenden Halbleiterchip (3), wobei der aussendende Halbleiterchip(3) in der ersten Kavität (6) angeordnet ist,
- zumindest einem eine elektromagnetische Strahlung detektierenden Halbleiterchip (4), wobei der detektierende Halbleiterchip(4) in der zweiten Kavität (7) angeordnet ist, wobei das Gehäuseunterteil (5) aus einem die ausgesendete elektromagnetische Strahlung absorbierenden oder reflektierenden Material ist, und
- einem Leiterrahmen (8), auf dem die Halbleiterchips (3, 4) angeordnet sind,
**dadurch gekennzeichnet, dass**
- das Halbleiterbauelement (1) einen dritten Halbleiterchip (11) aufweist, wobei der dritte Halbleiterchip (11) ein ASIC (Application Specific Integrated Circuit) oder ein ESD-Chip (Elektrostatic Discharge Chip) ist,
- der dritte Halbleiterchip (11) auf dem Leiterbahnrahmen (8) platziert und komplett mit dem Material des Gehäuseunterteils (5) umgossen ist, und
- der Leiterbahnrahmen (8) für die auszusendende und zu detektierende Strahlung undurchlässig ausgebildet ist und an einer der Oberseite (501) gegenüberliegenden Unterseite (502) des Gehäuseunterteils direkt elektrisch leitend kontaktierbar ist.

2. Halbleiterbauelement (1) nach Anspruch 1,
wobei der dritte Halbleiterchip (11) ein ASIC (Application Specific Integrated Circuit) ist, der integrierte Auswerteschaltungen des detektierenden Halbleiterchips (4) und Ansteuerschaltungen für den aussendenden Halbleiterchip (3) aufweist, sodass der dritte Halbleiterchip (11) dazu ausgebildet ist, zum einen das Aussenden der elektromagnetischen Strahlung und zum anderen die Auswertung der detektierten Strahlung zu steuern.

3. Halbleiterbauelement (1) nach einem der vorhergehenden Ansprüche, wobei das Halbleiterbauelement (1) ein Gehäuseoberteil (9) aufweist, wobei das Gehäuseoberteil (9) zumindest teilweise transparent für die auszusendende und die zu detektierende Strahlung ist.

4. Halbleiterbauelement (1) nach Anspruch 3, wobei das Gehäuseoberteil (9) ein optisches Element (10) ist.

5. Halbleiterbauelement (1) nach Anspruch 4, wobei das optische Element (10) eine Einzellinse oder ein Linsenarray ist.

6. Reflexlichtschranke enthaltend ein Halbleiterbauelement (1) nach einem der vorhergehenden Ansprüche.

7. Verfahren zur Herstellung eines Halbleiterbauelements nach einem der Ansprüche 1 bis 5 mit einem Gehäuse für eine Reflexlichtschranke mit den Verfahrensschritten:
- Bereitstellen eines Leiterbahnrahmens (8),
- Umspritzen des Leiterbahnrahmens (8) mit einer ersten Vergussmasse, derart, dass ein monolithisches Gehäuseunterteil (5) mit zumindest einer ersten und einer zweiten Kavität (6, 7) entsteht, wobei die Kavitäten (6, 7) zu einer Oberseite (501) des Gehäuseunterteils (5) geöffnet sind,
- Platzieren von zumindest einem eine elektromagnetische Strahlung aussendenden Halbleiterchip (3) innerhalb der ersten Kavität (6) auf dem Leiterbahnrahmen (8),
- Platzieren von zumindest einem eine elektromagnetische Strahlung detektierenden Halbleiterchip (4) innerhalb der zweiten Kavität (7) auf dem Leiterbahnrahmen (8),
- Elektrisches Verbinden der Halbleiterchips (3, 4) mit dem Leiterbahnrahmen (8),
**dadurch gekennzeichnet, dass**
- vor dem Umspritzen ein dritter Halbleiterchip (11) mit dem Leiterbahnrahmen (8) platziert und elektrisch leitend verbunden wird, wobei der dritte Halbleiterschritt (11) im Folgeschritt vollständig von der ersten Vergussmasse umspritzt wird, und wobei der dritte Halbleiterchip (11) ein ASIC (Application Specific Integrated Circuit) oder ein ESD-Chip (Elektrostatic Discharge Chip) ist,
- der dritte Halbleiterchip (11) bereits vor dem Herstellen des Gehäuseunterteils (5) auf dem Leiterbahnrahmen (8) platziert und komplett mit einem Material des Gehäuseunterteils (5) umgossen wird, und
- der Leiterbahnrahmen (8) für eine auszusendende und zu detektierende Strahlung undurchlässig ausgebildet ist und an einer der Oberseite (501) gegenüberliegenden Unterseite (502) des Gehäuseunterteils direkt elektrisch leitend kontaktierbar ist.

8. Verfahren nach Anspruch 7, wobei die Kavitäten (6, 7) mittels einer für die auszusendende und zu detektierende Strahlung transparenten zweiten Vergussmaterial vergossen werden.

9. Verfahren nach Anspruch 8, wobei das zweite Vergussmaterial zusätzlich als optisches Element (10) ausgeformt wird.

10. Verfahren nach Anspruch 9, wobei das optische Element mittels eines compression molding Verfahrens erzeugt wird.

11. Verfahren nach einem der Ansprüche 7 bis 10, wobei die erste Vergussmasse ein Epoxydharz, ein Silikon mit Füllstoffen oder eine Mischung aus Epoxydharz und Silikon mit Füllstoffen ist.

## Claims

1. Semiconductor component (1) having:
- a monolithic housing lower part (5), wherein the housing lower part (5) has an upper side (501) and at least one first and one second cavity (6, 7), wherein the cavities (6, 7) are open to the upper side (501) of the housing lower part (5),
- at least one semiconductor chip (3) emitting electromagnetic radiation, wherein the emitting semiconductor chip (3) is arranged in the first cavity (6),
- at least one semiconductor chip (4) detecting electromagnetic radiation, wherein the detecting semiconductor chip (4) is arranged in the second cavity (7), wherein the housing lower part (5) is made of a material absorbing or reflecting the emitted electromagnetic radiation, and
- a conductor frame (8) on which the semiconductor chips (3, 4) are arranged,
**characterized in that**,
- the semiconductor component (1) has a third semiconductor chip (11), wherein the third semiconductor chip (11) is an ASIC (Application Specific Integrated Circuit) or an ESD chip (Electrostatic Discharge Chip),
- the third semiconductor chip (11) is placed on the conductor track frame (8) and cast completely with the material of the housing lower part (5), and
- the conductor track frame (8) is formed to be impermeable to the radiation to be emitted and detected, and is directly contactable in an electrically-conductive manner on an underside (502), located opposite to the upper side (501), of the housing lower part.

2. Semiconductor component (1) according to claim 1,
wherein the third semiconductor chip (11) is an ASIC (Application Specific Integrated Circuit) which has integrated analysis circuits of the detecting semiconductor chip (4) and control circuits for the emitting semiconductor chip (3), so that the third semiconductor chip (11) is formed to control, on the one hand, the emission of the electromagnetic radiation and, on the other, the analysis of the detected radiation.

3. Semiconductor component (1) according to one of the preceding claims, wherein the semiconductor component (1) has a housing upper part (9), wherein the housing upper part (9) is at least partially transparent to the radiation to be emitted and the radiation to be detected.

4. Semiconductor component (1) according to claim 3, wherein the housing upper part (9) is an optical element (10).

5. Semiconductor component (1) according to claim 4, wherein the optical element (10) is a single lens or a lens array.

6. Reflex light barrier containing a semiconductor component (1) according to one of the preceding claims.

7. Method for manufacturing a semiconductor component according to one of claims 1 through 5, having a housing for a reflected light barrier, with the method steps of:
- providing a conductor track frame (8),
- coating the conductor track frame (8) with a first potting compound in such a way that a monolithic housing lower part (5) with at least one first and one second cavity (6, 7) is created, wherein the cavities (6, 7) are open to an upper side (501) of the housing lower part (5),
- positioning at least one semiconductor chip (3) emitting electromagnetic radiation within the first cavity (6) on the conductor track frame (8),
- positioning at least one semiconductor chip (4) detecting electromagnetic radiation within the second cavity (7) on the conductor track frame (8),
- electrically connecting the semiconductor chips (3, 4) to the conductor track frame (8),
**characterized in that**,
- before the coating, a third semiconductor chip (11) is placed on and connected in an electrically-conductive manner to the conductor track frame (8), wherein the third semiconductor chip (11) is completely coated in the subsequent step with the first potting compound, and wherein the third semiconductor chip (11) is an ASIC (Application Specific Integrated Circuit) or an ESD Chip (Electrostatic Discharge Chip),
- the third semiconductor chip (11) is already placed on the conductor track frame (8) prior to the production of the housing lower part (5) and cast completely with a material of the housing lower part (5), and
- the conductor track frame (8) is formed to be impermeable to radiation to be emitted and detected, and is directly contactable in an electrically-conductive manner on an underside (502), located opposite to the upper side (501), of the housing lower part.

8. Method according to claim 7, wherein the cavities (6, 7) are cast using a second potting material which is transparent to the radiation to be emitted and to be detected.

9. Method according to claim 8, wherein the second potting material is formed additionally as an optical element (10).

10. Method according to claim 9, wherein the optical element is produced by a compression molding process.

11. Method according to one of claims 7 through 10, wherein the first potting compound is an epoxy resin, a silicone with fillers, or a mixture of epoxy resin and silicone with fillers.

## Revendications

1. Composant semiconducteur (1) comprenant :
- une partie inférieure de boîtier monolithique (5), dans lequel la partie inférieure de boîtier (5) présente une face supérieure (501) et présente au moins une première et une seconde cavité (6, 7), dans lequel les cavités (6,7) sont ouvertes vers la face supérieure (501) de la partie inférieure de boîtier (5),
- au moins une puce semiconductrice (3) émettant un rayonnement électromagnétique, dans lequel la puce semiconductrice émettrice (3) est disposée dans la première cavité (6),
- au moins une puce semiconductrice (4) détectant un rayonnement électromagnétique, dans lequel la puce semiconductrice détectrice (4) est disposée dans la seconde cavité (7), dans lequel la partie inférieure de boîtier (5) est constituée d'un matériau absorbant ou réfléchissant le rayonnement électromagnétique émis et
- un cadre conducteur (8), sur lequel les puces semiconductrices (3, 4) sont disposées,
**caractérisé en ce que**
- le composant semiconducteur (1) présente une troisième puce semiconductrice (11), dans lequel la troisième puce semiconductrice (11) est un ASIC (circuit intégré spécifique à l'application) ou une puce ESD (puce à décharge électrostatique),
- la troisième puce semiconductrice (11) est placée sur le cadre de pistes conductrices (8) et enrobée par coulée totalement avec le matériau de la partie inférieure de boîtier (5) et
- le cadre de pistes conductrices (8) est conçu imperméable pour le rayonnement à émettre et à détecter et peut être mis en contact électroconducteur direct sur une face inférieure (502) de la partie inférieure de boîtier opposée à la face supérieure (501).

2. Composant semiconducteur (1) selon la revendication 1,
dans lequel la troisième puce semiconductrice (11) est un ASIC (circuit intégré spécifique à l'application), qui présente des circuits d'évaluation intégré de la puce semiconductrice détectrice (4) et des circuits d'évaluation pour la puce semiconductrice émettrice (3), de sorte que la troisième puce semiconductrice (11) soit conçu pour commander d'une part l'émission du rayonnement électromagnétique et d'autre part l'évaluation du rayonnement détecté.

3. Composant semiconducteur (1) selon une des revendications précédentes, dans lequel le composant semiconducteur (1) présente une partie supérieure de boîtier (9), dans lequel la partie supérieure de boîtier (9) est au moins partiellement transparente pour le rayonnement à émettre et à détecter.

4. Composant semiconducteur (1) selon la revendication 3, dans lequel la partie supérieure de boîtier (9) est un élément optique (10).

5. Composant semiconducteur (1) selon la revendication 4, dans lequel l'élément optique (10) est une lentille unique ou un réseau de lentilles.

6. Barrière photoélectrique à réflexion comprenant un composant semiconducteur (1) selon une des revendications précédentes.

7. Procédé de fabrication d'un composant semiconducteur selon une des revendications 1 à 5, avec un boîtier pour une barrière photoélectrique à réflexion, comprenant les étapes de procédé :
- préparation d'un cadre de pistes conductrices (8),
- surmoulage du cadre de pistes conductrices (8) avec une première masse de scellement, de manière à produire une partie inférieure de boîtier monolithique (5) avec au moins une première et une seconde cavité (6, 7), dans lequel les cavités (6, 7) sont ouvertes vers une face supérieure (501) de la partie inférieure de boîtier (5),
- mise en place d'au moins une puce semiconductrice (3) émettant un rayonnement électromagnétique à l'intérieur de la première cavité (6) sur le cadre de pistes conductrices (8),
- mise en place d'au moins une puce semiconductrice (4) détectant un rayonnement électromagnétique à l'intérieur de la seconde cavité (7) sur le cadre de pistes conductrices (8),
- connexion électrique des puces semiconductrices (3, 4) avec le cadre de pistes conductrices (8),
**caractérisé en ce que**
- avant le surmoulage, une troisième puce semiconductrice (11) est placée et connectée de manière électroconductrice avec le cadre de pistes conductrices (8), dans lequel la troisième puce semiconductrice (11), dans l'étape suivante, est totalement enrobée par coulée par la première masse de scellement et dans lequel la troisième puce semiconductrice (11) est un ASIC (circuit intégré spécifique à l'application) ou une puce ESD (puce à décharge électrostatique),
- la troisième puce semiconductrice (11) est placée sur le cadre de pistes conductrices (8) déjà avant la fabrication de la partie inférieure de boîtier (5) et enrobée par coulée totalement avec un matériau de la partie inférieure de boîtier (5) et
- le cadre de pistes conductrices (8) est conçu imperméable pour un rayonnement à émettre et à détecter et peut être mis en contact électroconducteur direct sur une face inférieure (502) de la partie inférieure de boîtier opposée à la face supérieure (501).

8. Procédé selon la revendication 7, dans lequel les cavités (6, 7) sont coulées au moyen d'un deuxième matériau de coulée transparent pour le rayonnement à émettre et à détecter.

9. Procédé selon la revendication 8, dans lequel le deuxième matériau de coulée est formé en outre comme un élément optique (10).

10. Procédé selon la revendication 9, dans lequel l'élément optique est fabriqué au moyen d'un procédé de moulage par compression.

11. Procédé selon une des revendications 7 à 10, dans lequel la première masse de scellement est une résine époxyde, une silicone avec des charges ou un mélange de résine époxyde et de silicone avec des charges.
